# EUROPÄISCHE PATENTANMELDUNG

(11) **EP 2 060 662 A2**
(43) Veröffentlichungstag der Anmeldung: **20.05.2009**
(21) Anmeldenummer: 08019625.6
(22) Anmeldetag: 10.11.2008
(51) Int. Cl.: C30B 23/02, C30B 25/02, C30B 29/40, C30B 23/06

(54) **MBE-Einrichtung und Verfahren zu deren Betrieb**

(30) Priorität: 16.11.2007 DE 102007054851
(71) Anmelder: Forschungsverbund Berlin E.V., 12489 Berlin (DE); CreaTec Fischer & Co. GmbH, 74391 Erligheim (DE)
(72) Erfinder: Schönherr, Hans-Peter, 13407 Berlin (DE); Fischer, Albrecht, 74369 Löchgau (DE)
(74) Vertreter: Hertz, Oliver

(57) **Zusammenfassung**

Eine Molekularstrahlepitaxie-(MBE)-Einrichtung (100), die zur reaktiven Abscheidung eines Gruppe III-Nitrid-Verbindungshalbleiters eingerichtet ist, umfasst eine Vakuumkammer (10), die mindestens eine Molekularstrahl-Quelle (11) und mindestens einen Injektor (12) aufweist, der zur Injektion von Ammoniak in die Vakuumkammer (10) eingerichtet ist, eine erste Kühlfalleneinrichtung (20) mit mindestens einer Kühlfalle (21, 22), die zum Kondensieren von überschüssigem Ammoniak eingerichtet ist, eine Pumpeneinrichtung (30) mit mindestens einer Pumpe (31, 33, 35), die zur Evakuierung der Vakuumkammer (10) eingerichtet ist, und eine Sperreinrichtung (40), mit der die erste Kühlfalleneinrichtung (20) von der Vakuumkammer (10) trennbar ist. Es wird auch ein Verfahren zum Betrieb einer MBE-Einrichtung beschrieben.

## Beschreibung

Die Erfindung betrifft eine Molekularstrahlepitaxie-Einrichtung (MBE-Einrichtung), die zur reaktiven Abscheidung eines Gruppe III-Nitrid-Halbleiters vorgesehen ist, und ein Verfahren zum Betrieb einer MBE-Einrichtung, bei dem ein Gruppe-III-Nitrid-Verbindungshalbleiter unter Verwendung von Ammoniak reaktiv abgeschieden wird.

Gruppe-III-Nitrid-Verbindungshalbleiter werden insbesondere zur Herstellung von lichtemittierenden Bauteilen, wie z. B. von Leuchtdioden oder Laserdioden auf der Basis von GaN verwendet. Es sind verschiedene Verfahren bekannt, Gruppe III-Nitrid-Verbindungshalbleiter schichtförmig abzuscheiden. Beim MOCVD-Verfahren ("metal organic chemical vapor deposition") erfolgt eine reaktive Abscheidung des Verbindungshalbleiters, bei der am Substrat Stickstoff mit einer komplexen organischen Verbindung der Gruppe V-Elemente, z. B. Galliumtrimethyl in Verbindung gebracht wird. Das MOCVD-Verfahren ist dahingehend nachteilig, dass die während der reaktive Abscheidung erforderlichen Vakuumbedingungen nur beschränkt mit Standardtechniken der Ultrahochvakuumtechnologie kompatibelsind. Somit können wichtige in-situ Kontrollen (wie z. B. RHEED) des Wachstumsprozesses nicht ausgeführt werden.

Alternativ können Gruppe III-Nitrid-Verbindungshalbleiter mit dem MBE-Verfahren (Molekularstrahlepitaxie-Verfahren) abgeschieden werden. Bei einer ersten Variante des MBE-Verfahrens wird molekularer Stickstoff mit einer Plasmaquelle (Radiofrequenz-(RF)- oder Elektronenzyklotronresonanz-(ECR)-Quelle) bereitgestellt. Diese Technik hat jedoch Nachteile wegen der Erzeugung störender Stickstoff-Ionen und wegen einer relativ geringen Wachstumsrate. Bei einer zweiten Variante wird molekularer Stickstoff durch eine thermische Zersetzung von Ammoniak (NH₃) bereitgestellt (reaktive Molekularstrahlepitaxie). Ein Problem der reaktiven Molekularstrahlepitaxie besteht darin, dass einerseits relativ viel Ammoniak zur thermischen Zersetzung am Substrat bereitgestellt werden soll und andererseits zur Aufrechterhaltung eines ausreichenden Hochvakuums überschüssiger Ammoniak möglichst schnell abgepumpt werden soll. Dieses Problem ist besonders kritisch, wenn bei der Schichtabscheidung eine hohe Wachstumsrate erzielt werden soll.

Ammoniakgas wird mit chemisch beständigen Turbomolekularpumpen abgepumpt. Andere Pumpentypen sind wegen ihrer geringen Saugleistung (Ionenpumpen) oder wegen ihrer beschränkten chemischen Beständigkeit (Kryopumpen) für das Pumpen von Ammoniak weniger geeignet. Turbomolekularpumpen haben allerdings auch den Nachteil, dass die typische Saugleistung (z. B. 1500 l/s) in der Praxis nicht ausreichend ist, um die beim reaktiven MBE-Verfahren anfallende Menge von Ammoniakgas bei einem ausreichenden Kammerdruck (z. B. 5 · 10⁻⁵ mbar während des Epitaxieprozesses) zu pumpen. Zur Unterstützung der Turbomolekularpumpe werden daher Kühlschilde (Cryopanels, Cryoshrouds) verwendet.

In kommerziellen MBE-Anlagen werden Kühlschilde, die mit flüssigem Stickstoff gekühlt sind, verwendet, um Restgase zu binden. Aus der Praxis sind Versuche bekannt, auch den überschüssigen Ammoniak an Kryoschilden auszufrieren. Dabei ist das Problem aufgetreten, dass nach dem Epitaxieprozess, wenn die Kühlschilde zur Freigabe des Ammoniaks aufgetaut werden, der gefrorene Ammoniak bei einer bestimmten Temperatur schlagartig verdampft und dadurch eine starke Erhöhung des Kammerdrucks bewirkt. Dieser Effekt wird noch durch den Wärmetransport von Effusionszellen in der MBE-Anlage zum Kühlschild verstärkt. Der Druck kann bis in den mbar-Bereich ansteigen, was zum unerwünschten Kollabieren der Turbomolekularpumpen führt.

Durch den explosionsartigen Druckeinbruch, der bei der Regeneration der Kühlschilde zur Freigabe des Ammoniaks auftritt, wird somit ein Wachstumszyklus bei einer Substratbeschichtung unterbrochen. Ein kontinuierlicher Betrieb der MBE-Anlage unter praktischen Produktionsbedingungen ist dadurch ausgeschlossen.

Die Aufgabe der Erfindung ist es, eine verbesserte Molekularstrahlepitaxie-Einrichtung (MBE-Einrichtung) bereitzustellen, mit der die Nachteile der herkömmlichen MBE-Techniken vermieden werden und die insbesondere eine zuverlässige Abfuhr von Ammoniakgas ermöglicht. Die MBE-Einrichtung soll insbesondere für einen kontinuierlichen Betrieb geeignet sein. Die Aufgabe der Erfindung ist es auch, ein verbessertes Verfahren für die reaktive MBE von Nitridverbindungen bereitzustellen, mit dem die Nachteile, wie z. B. stark ansteigender Basiskammerdruck während der Kühlschildauswärmphase, der herkömmlichen Techniken vermieden werden.

Diese Aufgaben werden durch eine MBE-Einrichtung und ein Verfahren zum Betrieb einer MBE-Einrichtung mit den Merkmalen der unabhängigen Ansprüche gelöst. Vorteilhafte Ausführungsformen und Anwendungen der Erfindung ergeben sich aus den abhängigen Ansprüchen.

Gemäß einem ersten Gesichtspunkt beruht die Erfindung auf der allgemeinen technischen Lehre, eine MBE-Einrichtung, die zur reaktiven Abscheidung eines Gruppe III-Nitrid-Verbindungshalbleiters in einer evakuierbaren Vakuumkammer (Wachstumskammer) vorgesehen ist, mit einer ersten Kühlfalleneinrichtung bereitzustellen, die zum Kondensieren von Ammoniak eingerichtet und die mit einer Sperreinrichtung von der Vakuumkammer trennbar (abkoppelbar) ist. Die erste Kühlfalleneinrichtung ist dazu vorgesehen, bei Betrieb der MBE-Einrichtung überschüssigen Ammoniak aus der Vakuumkammer auszufrieren. Zur Regeneration der ersten Kühlfalleneinrichtung (Freigabe des Ammoniaks) kann die Verbindung zwischen der Kühlfalleneinrichtung und der Vakuumkammer durch die Sperreinrichtung geschlossen werden, so dass bei der Freigabe des Ammoniaks aus der ersten Kühlfalleneinrichtung, z. B. durch deren Erwärmung, das Vakuum in der Vakuumkammer erhalten bleibt. Ein Druckanstieg und damit eine unerwünschte Beeinflussung des MBE-Abscheideprozesses in der Vakuumkammer wird vermieden.

Die Erfinder haben festgestellt, dass es für die Wirkung der ersten Kühlfalleneinrichtung vorteilhafterweise nicht zwingend erforderlich ist, dass diese unmittelbar in der Vakuumkammer angeordnet ist. Das gewünschte Kondensieren des überschüssigen Ammoniaks kann auch erzielt werden, wenn die erste Kühlfalleneinrichtung durch die verschließbare Sperreinrichtung von der Vakuumkammer getrennt ist. Die Ausbreitung des Ammoniakpartialdruckes ermöglicht, dass das Ausfrieren des Ammoniaks durch die geöffnete Sperreinrichtung in der ersten Kühlfalleneinrichtung erfolgt. Als Sperreinrichtung kann jede vakuumtechnische Komponente, wie z. B. ein Ventil oder ein UHV-Schieber, verwendet werden, mit der eine Verbindung zwischen der Kühlfalleneinrichtung und der Vakuumkammer druckdicht (vakuumdicht) verschlossen werden kann.

Gemäß einem zweiten Gesichtspunkt basiert die Erfindung auf der allgemeinen technischen Lehre, ein Verfahren zum Betrieb einer MBE-Einrichtung, insbesondere ein Verfahren zur Abscheidung eines Gruppe III-Nitrid-Verbindungshalbleiters mittels reaktiver Molekularstrahlepitaxie in einer Vakuumkammer bereitzustellen, bei dem zur Freigabe von Ammoniak, der an einer ersten Kühlfalleneinrichtung kondensiert ist, die erste Kühlfalleneinrichtung mit einer Sperreinrichtung von der Vakuumkammer getrennt wird. Mit der Betätigung der Sperreinrichtung wird die erste Kühlfalleneinrichtung in Bezug auf die Vakuumkammer druckdicht verschlossen, so dass ein Druckanstieg in der ersten Kühlfalleneinrichtung für den MBE-Abscheidungsprozess in der Vakuumkammer unkritisch ist.

Von besonderem Vorteil ist, dass die Vakuumkammer der MBE-Einrichtung in allen Betriebsphasen, insbesondere während der Regeneration der ersten Kühlfalleneinrichtung, unter Ultrahochvakuum-Bedingungen bleiben kann. Ein Druckanstieg und ein eventuelles Herunterfahren der Molekularstrahlquellen auf Raumtemperatur während des Aufwärmens der ersten Kühlfalleneinrichtung in der Vakuumkammer kann vermieden werden. Diese Vorteile wirken sich besonders bei der Abscheidung von Gruppe III-Nitrid-Verbindungshalbleiterschichten aus, da ohne eine Beeinträchtigung des Betriebs der MBE-Einrichtung mit konstanten Flüssen der Molekularstrahlquellen und Ammoniakpartialdruck gearbeitet werden kann. Die Erfindung ermöglicht eine im Vergleich zum herkömmlichen reaktiven MBE-Verfahren bessere Reproduzierbarkeit der Wachstumsrate und eine verbesserte Qualität der Verbindungshalbleiterschichten.

Ein weiterer Vorteil ist die Flexibilität bei der Ankopplung der ersten Kühlfalleneinrichtung an die Vakuumkammer. Die Bereitstellung der Sperreinrichtung kann problemlos an den konkreten Aufbau der MBE-Einrichtung angepasst werden. Beispielsweise kann die erste Kühlfalleneinrichtung gemäß einer bevorzugten Ausführungsform mindestens eine Kühlfalle umfassen, die zwischen der Vakuumkammer und einer Pumpeneinrichtung angeordnet ist, mit der die Vakuumkammer evakuierbar ist. Diese Ausführungsform der Erfindung hat den besonderen Vorteil, dass die Pumpeneinrichtung eine Vorzugsrichtung der Strömung aus der Vakuumkammer bereitstellt, mit der auch das überschüssige Ammoniak zur Kühlfalle geführt wird.

Alternativ oder zusätzlich kann die erste Kühlfalleneinrichtung mindestens eine Kühlfalle umfassen, die in einer Zusatz-vakuumkammer angeordnet ist, die über die Sperreinrichtung mit der Vakuumkammer verbunden ist. Diese Ausführungsform der Erfindung hat den besonderen Vorteil, dass eine vorhandene MBE-Einrichtung mit geringem Aufwand nachgerüstet werden kann, indem an die Vakuumkammer über eine Vakuumverbindung die Zusatz-Vakuumkammer angeschlossen und in dieser die Kühlfalle angeordnet wird. Die Zusatz-Vakuumkammer ist vorzugsweise mit einer Vakuumpumpe der Pumpeneinrichtung verbunden. Damit kann eine Strömung von der Vakuumkammer zur Zusatz-Vakuumkammer und die Aufnahme von Ammoniak am Kühlschild verbessert werden.

Die Pumpeneinrichtung kann mindestens eine Vakuumpumpe umfassen, die zur Evakuierung der Vakuumkammer über mindestens eine Vakuumverbindung eingerichtet ist. Als Vakuumpumpe kann jeder Pumpentyp verwendet werden, z. B. bevorzugt eine Kombination aus einer Turbomolekularpumpe und einer Vorpumpe. Alternativ oder zusätzlich können mindestens eine Ionenpumpe und/oder Kryopumpe vorgesehen sein.

Die oben zuerst genannte Ausführungsform der Erfindung, bei der die mindestens eine Kühlfalle in einer Vakuumverbindung zwischen der Vakuumkammer und mindestens einer Vakuumpumpe angeordnet ist, kann mit verschiedenen Varianten realisiert werden. Gemäß einer ersten Variante ist eine einzige Kühlfalle in einer Vakuumverbindung zwischen der Vakuumkammer und der Pumpeneinrichtung vorgesehen. Die Sperreinrichtung umfasst ein einziges Sperrelement, das in der Vakuumverbindung zwischen der Vakuumkammer und der Kühlfalle angeordnet ist. In diesem Fall ergeben sich Vorteile durch einen einfachen Aufbau der MBE-Einrichtung. Gemäß einer zweiten Variante sind mehrere Kühlfallen, z. B. zwei Kühlfallen, zwischen der Vakuumkammer und der Pumpeneinrichtung parallel geschaltet, angeordnet. Es können z. B. zwei oder mehrere Vakuumverbindungen zwischen der Vakuumkammer und der Pumpeneinrichtung vorgesehen sein, in denen jeweils eine Kühlfalle angeordnet ist. Die Sperreinrichtung umfasst in diesem Fall mehrere Sperrelemente, z. B. zwei Sperrelemente. Jedes Sperrelement ist einer der Kühlfallen zugeordnet und zwischen der Vakuumkammer und der jeweiligen Kühlfalle angeordnet. Die zweite Variante mit mehreren Kühlfallen hat den besonderen Vorteil, dass ein alternierender Betrieb ermöglicht wird. Während eine Kühlfalle zur Regeneration und Freigabe des Ammoniaks von der Vakuumkammer entkoppelt ist, kann die Evakuierung der Vakuumkammer über die zweite Kühlfalle (oder weitere Kühlfallen) erfolgen. Es wird eine alternierende Betriebsweise realisiert, die einen vollständig unterbrechungsfreien Betrieb der MBE-Einrichtung ermöglicht.

Vorzugsweise umfasst die mindestens eine Kühlfalle ein rohrförmiges Baffle, das zwischen der Vakuumkammer und der Pumpeneinrichtung angeordnet ist. Das Baffle ist zur Kondensation von Ammoniak mit flüssigem Stickstoff gekühlt. Die Verwendung des Baffles hat den Vorteil, dass eine große innere Oberfläche zur effektiven Kondensation von Ammoniak bereitgestellt wird. Alternativ umfasst die mindestens eine Kühlfalle ein Kühlschild, das z. B. in der Zusatz-Vakuumkammer angeordnet ist. Das Kühlschild wird zur Kondensation von Ammoniak mit flüssigem Stickstoff gekühlt. Vorteilhafterweise wird durch die Bereitstellung des Kühlschildes in der Zusatz-Vakuumkammer ein effektives Auffallen von Ammoniakgas ermöglicht, wobei die Struktur der Vakuumanlage insbesondere der Vakuumkammer und der Verbindung zur Pumpeneinrichtung unverändert bleiben kann.

Gemäß einer weiteren vorteilhaften Ausführungsform der Erfindung ist die mindestens eine Kühlfalle unabhängig von der Vakuumkammer evakuierbar. Die mindestens eine Kühlfalle kann insbesondere in einem Betriebszustand, in dem die Verbindung zur Vakuumkammer durch die Sperreinrichtung geschlossen ist, mit einer Vakuumpumpe abgepumpt werden. Damit wird vorteilhafterweise die Abfuhr des bei Erwärmung der Kühlfalle freigegebene Ammoniaks beschleunigt. Besonders bevorzugt wird die Pumpeneinrichtung der MBE-Einrichtung zum Abpumpen der mindestens einen Kühlfalle verwendet. Hierzu kann die Kühlfalle bei geschlossener Sperreinrichtung z. B. mit der Turbomolekularpumpe der Pumpeneinrichtung direkt abgepumpt werden. Alternativ kann vorgesehen sein, dass die Kühlfalle mit einer Vorpumpe der Turbomolekularpumpe abgepumpt wird. Damit kann vorteilhafterweise ein Kollabieren der Turbomolekularpumpe vermieden werden.

Für die Evakuierung der mindestens einen Kühlfalle mit einer Vorpumpe der Pumpeneinrichtung ist gemäß einer besonders bevorzugten Gestaltung der erfindungsgemäßen MBE-Einrichtung eine absperrbare Überbrückungsleitung (Bypassleitung) vorgesehen, über welche die mindestens eine Kühlfalle mit der Vorpumpe verbunden ist. Zur Freigabe von Ammoniak aus der Kühlfalle wird die Sperreinrichtung, insbesondere das Sperrelement zwischen der Vakuumkammer und der Kühlfalle, und ein weiteres Sperrelement zwischen der Kühlfalle und der Turbomolekularpumpe geschlossen, während die Überbrückungsleitung geöffnet wird.

Gemäß einer weiteren, besonders vorteilhaften Variante der Erfindung ist die Vakuumkammer mit einer zweiten Kühlfalleneinrichtung ausgestattet, die dazu eingerichtet ist, Restgas in der Vakuumkammer aufzufangen. Vorteilhafterweise kann insbesondere eine in der Vakuumkammer angeordnete Kühlfalleneinrichtung, die bei kommerziellen MBE-Anlagen standardmäßig vorhanden ist, verwendet werden. Die zweite Kühlfalleneinrichtung dient vorzugsweise dem Ausfrieren ausschließlich von Restgas, das kein Ammoniakgas enthält. Hierzu ist die zweite Kühlfalleneinrichtung, die z. B. ein Kühlschild umfasst, zum Betrieb bei einer Temperatur eingerichtet, die unterhalb der Kondensationstemperatur von einigen Restgasen, wie z. B. H₂O, in der Vakuumkammer und oberhalb der Kondensationstemperatur von Ammoniak gewählt ist. Die zweite Kühlfalleneinrichtung ist vorzugsweise mit einem Umwälzkühler ausgestattet, der als Kühlmittel z. B. Alkohol oder Silikonöl enthält. Die Temperatur der zweiten Kühlfalleneinrichtung ist z. B. im Bereich von - 85°C bis -65 °C gewählt.

Weitere Einzelheiten und Vorteile der Erfindung werden im Folgenden unter Bezug auf die beigefügten Zeichnungen erläutert. Es zeigen:

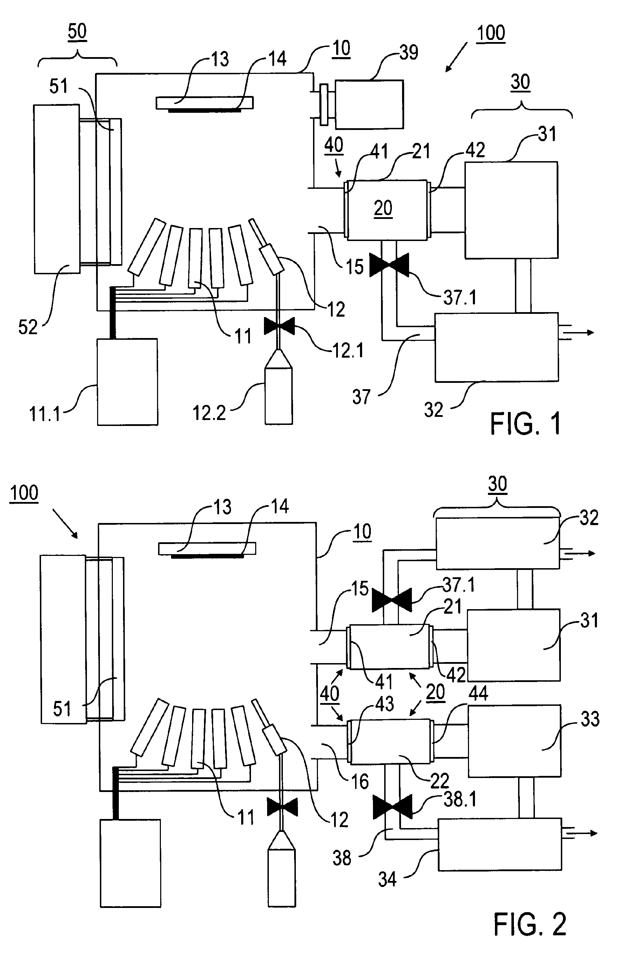

- Figuren 1 bis 3:: schematische Illustrationen von Ausfüh- rungsformen der erfindungsgemäßen MBE-Einrich- tung.

Ausführungsformen der erfindungsgemäßen MBE-Einrichtung und eines MBE-Verfahrens werden im Folgenden insbesondere unter Bezug auf die Eigenschaften der Kühlfalleneinrichtungen und der Sperreinrichtung und von deren Betrieb erläutert. Einzelheiten der MBE-Einrichtung, soweit diese aus der herkömmlichen MBE-Technik bekannt sind, wie z. B. Schleusen oder Messgeräte, werden nicht beschrieben. Die Realisierung der Erfindung ist nicht auf die schematisch (insbesondere nicht maßstabsgerecht) illustrierte MBE-Einrichtung mit einer einzelnen Vakuumkammer beschränkt, sondern entsprechend mit einer MBE-Anlage möglich, wie sie in der kommerziellen Produktion zum ununterbrochenen Betrieb für die Herstellung von Gruppe III-Nitrid-Verbindungshalbleiter-Schichten verwendet wird. Einzelheiten der reaktiven Abscheidung des Verbindungshalbleiters, insbesondere der Auswahl von Betriebsparametern, werden realisiert, wie dies von dem herkömmlichen reaktiven MBE-Verfahren für die Abscheidung kristalliner Nitridschichten bekannt ist.

Figur 1 illustriert eine erste Ausführungsform der erfindungsgemäßen MBE-Einrichtung 100 mit einer Vakuumkammer 10, einer ersten Kühlfalleneinrichtung 20, einer Pumpeneinrichtung 30, einer Sperreinrichtung 40 und einer zweiten Kühlfalleneinrichtung 50. Bei dieser Ausführungsform ist eine einzige Verbindung zwischen der Vakuumkammer 10 und der Pumpeneinrichtung 30 vorgesehen, wobei die erste Kühlfalleneinrichtung 20 eine einzige Kühlfalle 21 umfasst, die zwischen der Vakuumkammer 10 und der Pumpeneinrichtung 30 angeordnet ist.

Die Vakuumkammer 10 umfasst einen Rezipienten, in dem mindestens eine Molekularstrahl-Quelle 11, mindestens ein Injektor 12 für ein Reaktivgas und eine Substrathalterung mit Heizung zum Heizen des Substrates 13 zur Aufnahme eines zu beschichtenden Substrats 14 angeordnet sind. Es sind bspw. mehrere Molekularstrahl-Quellen 11 vorgesehen, die mit einer Quellensteuerung 11.1 verbunden sind. Die Molekularstrahl-Quellen 11 umfassen z. B. Effusionszellen, wie sie aus der MBE-Technik bekannt sind. Der Injektor 12 ist über ein Dosierventil 12.1 mit einem Gasreservoir 12.2 verbunden. Weitere Komponenten der Vakuumkammer 10, wie z. B. Schleusen, Schieber und Messeinrichtungen, sind nicht dargestellt.

Zusätzlich ist in der Vakuumkammer 10 die zweite Kühlfalleneinrichtung 50 mit mindestens einem Kühlschild 51 (Cryoshroud) angeordnet, das mit einem Umwälzkühler 52 verbunden ist. Das mindestens eine Kühlschild 51 ist so aufgebaut, wie es an sich von herkömmlichen MBE-Einrichtungen bekannt ist. Vorzugsweise ist das Kühlschild 51 an mindestens einer der Wände der Vakuumkammer 10 angeordnet. Die Betriebstemperatur des Kühlschildes 51 ist vorzugsweise im Bereich von -85 °C bis -65 °C, z. B. bei -75 °C gewählt. Diese Temperatur wird insbesondere in Abhängigkeit vom Vakuumkammerdruck während des reaktiven Epitaxieprozesses gewählt, wobei sie aus dem Kondensationspunkt des Ammoniakgases ergibt, der vom Partialdruck des Ammoniakgases abhängig ist. Die Betriebstemperatur der zweiten Kühlfalleneinrichtung (Kühlschild) ist somit höher, als der Kondensationspunkt des Ammoniakgases unter den gegebenen Betriebsbedingungen der Vakuumkammer 10.

Die Vakuumkammer 10 ist über eine Vakuumverbindung 15 mit der Pumpeneinrichtung 30 verbunden. Die Vakuumverbindung 15 umfasst z. B. eine Kombination aus einem Flansch und einer Rohrleitung. Die Pumpeneinrichtung 30 umfasst als Hauptpumpe eine Turbomolekularpumpe 31, die mit einer Vorpumpe 32 ausgestattet ist. Die erste Kühlfalleneinrichtung 20 umfasst eine Kühlfalle in Form eines rohrförmigen Baffles 21 mit inneren Kühlflächen, das in die Vakuumverbindung 15 eingebaut ist. Das Baffle 21 wird mittels eines Umwälzkryostats (nicht dargestellt) mit flüssigem Stickstoff gekühlt. Das Baffle 21 ist in Abhängigkeit von den verfahrens- und vakuumtechnischen Parametern, insbesondere in Abhängigkeit von der Menge des zu kondensierenden Ammoniaks und der Saugleistung der Pumpeneinrichtung 30 dimensioniert. Des Weiteren ist die Vakuumkammer 10 ist über eine mit einem Ventil verschließbare Vakuumverbindung mit einer zusätzlichen UHV-Pumpe 39 (z. B. Ionengetterpumpe oder Turbopumpe) verbunden.

Auf Seiten der Vakuumkammer 10 ist als Sperrelement der Sperreinrichtung 40 ein Ventil 41 vorgesehen, mit dem der Strömungsweg von der Vakuumkammer 10 zum Baffle 21 vakuumdicht verschlossen werden kann. Das Ventil 41 umfasst z. B. ein UHV-Schieber. Auf Seiten der Pumpeneinrichtung 30 ist das Baffle 21 mit einem weiteren Sperrelement ausgestattet, dass ebenfalls ein Ventil 42 umfasst. Das Baffle 21 ist über eine Überbrückungsleitung 37 mit der Vorpumpe 32 der Pumpeneinrichtung 30 verbunden. In der Überbrückungsleitung 37 ist ein Bypass-Ventil 38 angeordnet.

Der Betrieb der MBE-Einrichtung 100 umfasst die folgenden Schritte. Zunächst erfolgt nach einer Beschickung der Molekularstrahl-Quellen 11 eine Evakuierung der Vakuumkammer 10. Hierzu werden die Ventile 41, 42 geöffnet, während das Bypass-Ventil 38 geschlossen ist. Die Evakuierung der Vakuumkammer 10 erfolgt mit der Turbomolekularpumpe 31 in Kombination mit der Vorpumpe 32. Das Beschicken und Evakuieren erfolgt nach allgemein üblichen Standard-Prozeduren für MBE-Anlagen und UHV-Kammern. Nach der Evakuierung kann ein (vorher behandeltes) Substrat 14 auf die Substrathalterung gebracht werden, wie es von herkömmlichen reaktiven MBE-Verfahren bekannt ist. Die Behandlung des Substrats 14 umfasst z. B. die vorherige Desorption von H₂O und/oder ein rückseitiges Sputtern, das für eine Verbesserung der thermischen Ankopplung bei der reaktiven Abscheidung des Verbindungshalbleiters vorgesehen ist, insbesondere falls das Substrat thermisch transparent ist.

Anschließend erfolgt für die reaktive Schichtabscheidung die Erzeugung von mindestens einem Molekularstrahl aus mindestens einer der Molekularstrahl-Quellen 11 und die Injektion von Ammoniak in die Vakuumkammer 10. Beispielsweise wird auf dem Substrat 14 eine GaN-Schicht abgeschieden. Vor dem Abscheidungsprozess kann die UHV-Pumpe 39 mit dem Ventil von der Vakuumkammer 10 abgetrennt sein. Während der Abscheidung des Verbindungshalbleiters wird der Betrieb der Pumpeneinrichtung 30 fortgesetzt. Mit dem Restgas, das aus der Vakuumkammer 10 über die Vakuumverbindung 13 abgepumpt wird, wird auch Ammoniakgas abtransportiert. Das Ammoniakgas wird am Baffle 21 der Kühlfalleneinrichtung 20 kondensiert. In Experimenten konnte als besonderer Vorteil der Erfindung festgestellt werden, dass an der Flüssig-Stickstoff-gekühlten Kühlfläche des Baffle 21 der Ammonik besonderes effektiv gepumpt wird, so dass sich die Pumpleistung um Faktor 10 (bezogen auf ein ungekühltes Baffle) erhöht.

Während des Beschichtungsbetriebes, der z. B. eine Dauer von einigen Stunden haben kann, schlägt sich laufend Ammoniak im Baffle 21 nieder. Für eine Regeneration der inneren Kühlflächen des Baffle 21 sind die folgenden Schritte vorgesehen. Zunächst erfolgt eine Abtrennung des Baffle 21 von der Vakuumkammer 10, indem das Ventil 41 geschlossen wird. Davor wird die UHV-Pumpe 39 mit der Vakuumkammer 10 verbunden. Die Kühlung des Baffle 21 wird abgeschaltet, so dass eine Erwärmung erfolgt. Das gefrorene Ammoniak wird mit steigender Temperatur in den gasförmigen Zustand überführt. Das Ammoniakgas wird mit der Turbomolekularpumpe 31 abgepumpt. Falls die Menge des Ammoniakgases zu groß für die Saugleistung der Turbomolekularpumpe 31 ist, wird das Ventil 42 geschlossen und das Bypass-Ventil 37.1 geöffnet. In diesem Zustand erfolgt ein Abpumpen des Baffle 21 mit der Vorpumpe 32 über die Überbrückungsleitung 37. Sobald ein ausreichend geringer Druck im Baffle 21 erreicht ist, kann das Bypass-Ventil 37.1 geschlossen werden. Das weitere Abpumpen bis zur Einstellung eines Ultrahochvakuums erfolgt dann mit der Turbomolekularpumpe 31. Schließlich wird das Ventil 41 wieder geöffnet, um während des weiteren Betriebes der MBE-Einrichtung die Vakuumkammer 10 zu evakuieren. Vorteilhafterweise kann die Freigabe des Ammoniaks aus dem Baffle 21 in einem längeren Zeitbereich von z. B. 12 h (Temperaturerhöhung von 77 K bis 300 K) realisiert werden, da der äußere Wärmeeintrag auf das Baffle 21 äußerst gering ist, wobei in der Vakuumkammer 10 ein ausreichendes Ultrahochvakuum durch die UHV-Pumpe 39 gehalten werden kann. Somit kann mit der Ausführungsform gemäß Figur 1 bereits ein normaler Arbeitstag-Betrieb (z. B. 8- bis 12 h-Betrieb) der MBE-Einrichtung 100, insbesondere ohne Unterbrechung des Wachstumszyklus der MBE-Abscheidung während üblicher Betriebszeiten, realisiert werden.

Eine weitere Ausführungsform der erfindungsgemäßen MBE-Einrichtung 100, die in Figur 2 gezeigt ist, umfasst zusätzlich zu dem oben beschriebenen Aufbau eine weitere Turbomolekularpumpe 33 mit einer Vorpumpe 34, die über eine weitere Vakuumverbindung 16 mit der Vakuumkammer 10 verbunden sind. In der Vakuumverbindung 16 ist eine weitere Kühlfalle der Kühlfalleneinrichtung 20 angeordnet. Die Kühlfalle umfasst ein weiteres Baffle 22, das auf Seiten der Vakuumkammer 10 mit einem weiteren Sperrelement, umfassend ein Ventil 43, verschlossen werden kann. Des Weiteren ist ein Ventil 44 zur Abkopplung des Baffle 22 von der Turbomolekularpumpe 33 und eine zweite Überbrückungsleitung 38 mit einem zweiten Überbrückungs-Ventil 38.1 als Bypass zwischen dem Baffle 22 und der Vorpumpe 34 vorgesehen. Bei der Ausführungsform gemäß Figur 2 ist die in Figur 1 gezeigte zusätzliche UHV-Pumpe 39 nicht vorgesehen. Eine zusätzliche UHV-Pumpe kann jedoch in Abhängigkeit von dem beabsichtigten Betrieb der MBE-Einrichtung 100 vorgesehen sein.

Der Betrieb der MBE-Einrichtung 100 gemäß Figur 2 erfolgt, wie dies oben und insbesondere in Bezug auf Figur 1 beschrieben wurde. Durch die doppelte Ausführung der Kombination aus Vakuumpumpen und Kühlfallen kann ein 24 h Dauerbetrieb (Herstellung von Verbindungshalbleitern) der Vakuumkammer 10 sichergestellt werden, auch wenn eines der Baffles 21, 22 zur Freigabe des Ammoniaks im abgekoppelten Zustand aufgeheizt und evakuiert wird.

Beispielsweise kann vorgesehen sein, dass zunächst das Baffle 21 regeneriert wird. Während die Ventile 43, 44 des zweiten Baffle 22 geöffnet bleiben und die Evakuierung der Vakuumkammer 10 mit der Turbomolekularpumpe 33 erfolgt, wird das erste Baffle 21 mit den Ventilen 41, 42 von der Vakuumkammer 10 und der Turbomolekularpumpe 31 abgekoppelt und über die Überprüfungs-Leitung 37 evakuiert. Nach einer Freigabe des Ammoniaks aus dem Baffle 21 kann diese wieder mit der Vakuumkammer 10 verbunden werden. Anschließend kann die Regeneration des zweiten Baffle 22 durch ein entsprechendes Schließen der Ventile 43, 44 und ein Evakuieren des Baffles 22 mit der Vorpumpe 34 bzw. der Turbomolekularpumpe 33 erfolgen.

Die in Figur 2 gezeigte Ausführungsform der Erfindung kann dahingehend abgewandelt sein, dass die Pumpeneinrichtung 30 eine einzige Vakuumpumpe 31 (mit einer Vorpumpe 32) umfasst, mit der die Baffle 21, 22 über getrennt ansteuerbare Ventile 42, 44 gemeinsam verbunden sein können.

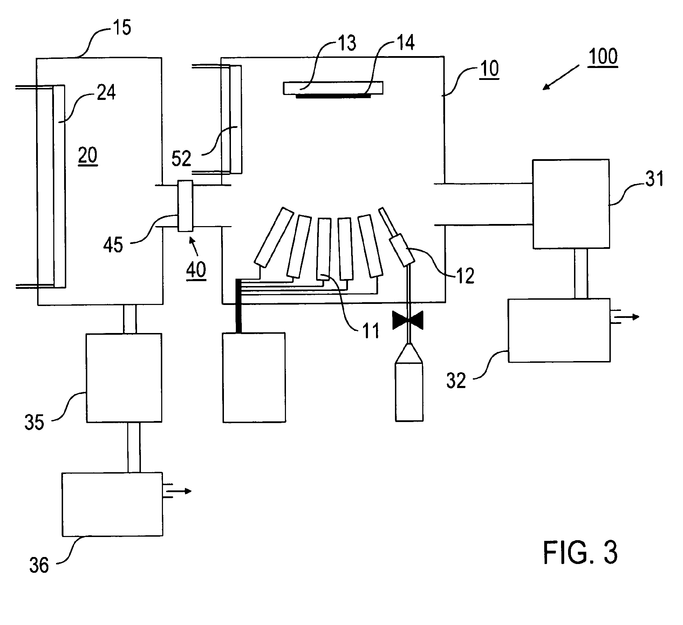

Figur 3 illustriert beispielhaft die weitere Ausführungsform der erfindungsgemäßen MBE-Einrichtung 100. In diesem Fall ist die Turbomolekularpumpe 31 mit der Vorpumpe 32 über eine Vakuumverbindung 15 mit der Vakuumkammer 10 verbunden, wie es von herkömmlichen MBE-Einrichtungen bekannt ist. Die Vakuumkammer 10 ist über eine Vakuumverbindung 17 mit einer Zusatz-Vakuumkammer 15 verbunden, in der als Kühlfalle der Kühlfalleneinrichtung 20 mindestens ein Kühlschild 23 angeordnet ist. Die Vakuumkammer 10 und die Zusatz-Vakuumkammer 15 sind über die Vakuumverbindung 17 gekoppelt, in der die Sperreinrichtung 40 vorgesehen ist. Als Sperrelement ist ein vakuumdichtes Ventil 45 in der Vakuumverbindung 17 vorgesehen. Die Zusatz-Vakuumkammer 15 kann mit einer weiteren Kombination aus einer Turbomolekularpumpe 35 und einer Vorpumpe 36 evakuiert werden.

Der Betrieb der in Figur 3 gezeigten MBE-Einrichtung 100 erfolgt im Wesentlichen, wie dies oben unter Bezug auf die Figur 1 beschrieben wurde. Während der Abscheidung des Verbindungshalbleiters erfolgt ein laufender Betrieb der Turbomolekularpumpe 33, mit der überschüssiger Ammoniak in die Zusatz-Vakuumkammer 15 gesogen wird. In dieser erfolgt die Kondensation des Ammoniaks an dem mit flüssigem Stickstoff gekühlten Kühlschild 23. Für eine Regeneration des Kühlschilds 23 wird das Ventil 45 geschlossen, so dass die Kühlfalleneinrichtung 20 von der Vakuumkammer 10 abgekoppelt ist. In diesem Zustand erfolgt eine Erwärmung des Kühlschilds 23 und eine Evakuierung der Zusatz-Vakuumkammer 15 mit der Turbomolekularpumpe 33. Nach dem Abpumpen des freigewordenen Ammoniakgases wird das Ventil 45 für den weiteren Betrieb der MBE-Einrichtung 100 geöffnet.

Die in den Figuren 1 bis 3 gezeigten Merkmale der Ausführungsform der erfindungsgemäßen MBE-Einrichtung können miteinander kombiniert werden. Beispielsweise können eine oder mehrere Kühlfallen als Baffle zwischen der Vakuumkammer 10 und der Pumpeneinrichtung 30 mit einem oder mehreren Kühlschilden in einer oder mehreren Zusatz-Vakuumkammern 15 kombiniert werden.

Die in der Beschreibung, den Ansprüchen und den Zeichnungen offenbarten Merkmale können sowohl einzeln als auch in Kombination für die Verwirklichung der Erfindung von Bedeutung sein.

## Patentansprüche

1. Molekularstrahlepitaxie-Einrichtung (MBE-Einrichtung) (100), die zur reaktiven Abscheidung eines Gruppe III-Nitrid-Verbindungshalbleiters eingerichtet ist, umfassend:
- eine Vakuumkammer (10), die mindestens eine Molekularstrahl-Quelle (11) und mindestens einen Injektor (12) aufweist, der zur Injektion von Ammoniak in die Vakuumkammer (10) eingerichtet ist,
- eine erste Kühlfalleneinrichtung (20) mit mindestens einer Kühlfalle (21, 22), die zum Kondensieren von überschüssigem Ammoniak eingerichtet ist, und
- eine Pumpeneinrichtung (30) mit mindestens einer Pumpe (31, 33, 35), die zur Evakuierung der Vakuumkammer (10) eingerichtet ist,
**gekennzeichnet durch**
- eine Sperreinrichtung (40), mit der die erste Kühlfalleneinrichtung (20) von der Vakuumkammer (10) trennbar ist.

2. MBE-Einrichtung gemäß Anspruch 1, bei der
- die erste Kühlfalleneinrichtung (20) eine Kühlfalle (21) umfasst, die zwischen der Vakuumkammer (10) und der Pumpeneinrichtung (30) angeordnet ist, wobei
- die Sperreinrichtung (40) ein Sperrelement (41) umfasst, das zwischen der Vakuumkammer (10) und der Kühlfalle (21) angeordnet ist.

3. MBE-Einrichtung gemäß Anspruch 2, bei der
- die erste Kühlfalleneinrichtung (20) mindestens zwei Kühlfallen (21, 22) umfasst, die in getrennten Vakuumverbindungen (13, 14) zwischen der Vakuumkammer (10) und der Pumpeneinrichtung (30) angeordnet ist, wobei
- die Sperreinrichtung (40) mindestens zwei Sperrelemente (41, 42) umfasst, die jeweils zwischen der Vakuumkammer (10) und den Kühlfallen (21, 22) angeordnet ist.

4. MBE-Einrichtung gemäß Anspruch 3, bei der
- die mindestens zwei Kühlfallen (21, 22) so konfiguriert sind, dass wenn eine der Kühlfallen (21, 22) durch die Sperreinrichtung (40) von der Vakuumkammer (10) getrennt ist, die jeweils andere der Kühlfallen (21, 22) mit der Vakuumkammer (10) verbunden ist, und wobei
- die jeweils von der Vakuumkammer (10) getrennte Kühlfalle (21, 22) zur Freigabe kondensierten Ammoniaks eingerichtet ist.

5. MBE-Einrichtung gemäß einem der vorhergehenden Ansprüche, bei der
- die mindestens eine Kühlfalle (21, 22) ein rohrförmiges Baffle umfasst, das entsprechend in einer Vakuumverbindung (13, 14) zwischen der Vakuumkammer (10) und einer Pumpe (31, 33) der Pumpeneinrichtung (30) angeordnet ist.

6. MBE-Einrichtung gemäß einem der vorhergehenden Ansprüche, bei der
- die mindestens eine Kühlfalle ein Kühlschild (23) umfasst, das in einer Zusatz-Vakuumkammer (15) angeordnet ist, wobei
- die Sperreinrichtung (40) ein Sperrelement (43) umfasst, das zwischen der Vakuumkammer (10) und der Zusatz-Vakuumkammer (15) angeordnet ist.

7. MBE-Einrichtung gemäß einem der vorhergehenden Ansprüche, bei der
- die mindestens eine Kühlfalle (21, 22, 23) von der Vakuumkammer (10) getrennt evakuierbar ist.

8. MBE-Einrichtung gemäß Anspruch 7, bei der
- die mindestens eine Kühlfalle (21, 22, 23) mit der Pumpeneinrichtung (30) evakuierbar ist.

9. MBE-Einrichtung gemäß Anspruch 8, bei der
- die mindestens eine Kühlfalle (21, 22, 23) mit mindestens einer Vorpumpe (32, 34, 36) der Pumpeneinrichtung (30) evakuierbar ist.

10. MBE-Einrichtung gemäß Anspruch 9, bei der
- die mindestens eine Kühlfalle (21, 22, 23) über eine absperrbare Überbrückungsleitung (37) mit der mindestens einen Vorpumpe (32, 34, 36) verbunden ist.

11. MBE-Einrichtung gemäß einem der vorhergehenden Ansprüche, die umfasst:
- eine zweite Kühlfalleneinrichtung(50), die zum Kondensieren von Restgas in der Vakuumkammer (10) eingerichtet ist.

12. MBE-Einrichtung gemäß Anspruch 11, bei der
- die zweite Kühlfalleneinrichtung (50) einen Kühlschild (51) umfasst, das in der Vakuumkammer (10) angeordnet ist.

13. MBE-Einrichtung gemäß Anspruch 11 oder 12, bei der
- die zweite Kühlfalleneinrichtung (50) für eine Betriebstemperatur ausgelegt ist, bei der Ammoniak unter Vakuumbedingungen im gasförmigen Zustand bleibt und Restgas in der Vakuumkammer (10) kondensiert.

14. Verfahren zum Betrieb einer MBE-Einrichtung (100), mit den Schritten:
- Evakuierung einer Vakuumkammer (10) der MBE-Einrichtung (100) mit einer Pumpeneinrichtung (30),
- Erzeugung eines Molekularstrahls eines Gruppe III-Elements in der Vakuumkammer (10),
- Injektion von Ammoniak in die Vakuumkammer (10), und
- reaktive Abscheidung eines Gruppe III-Nitrid-Verbindungshalbleiters auf einem Substrat (17.1) in der Vakuumkammer (10), wobei
- Ammoniak, der nicht zu der reaktiven Abscheidung beiträgt, an einer ersten Kühlfalleneinrichtung (20) kondensiert wird,
**dadurch gekennzeichnet dass**
- der Ammoniak von der Vakuumkammer (10) zur der ersten Kühlfalleneinrichtung (20) durch eine verschließbare Sperreinrichtung (40) strömt, mit der die erste Kühlfalleneinrichtung (20) von der Vakuumkammer (10) trennbar ist.

15. Verfahren gemäß Anspruch 14, mit den Schritten
- Verschließen der Sperreinrichtung (40), und
- Freigabe von kondensiertem Ammoniak aus der ersten Kühlfalleneinrichtung (20), wobei während der Freigabe die erste Kühlfalleneinrichtung (20) ein Hochvakuum im Inneren der Vakuumkammer (10) aufrecht erhalten wird.

16. Verfahren gemäß Anspruch 15, bei dem
- die erste Kühlfalleneinrichtung (20) zur Freigabe des Ammoniak erwärmt und evakuiert wird.

17. Verfahren gemäß Anspruch 16, bei dem
- die erste Kühlfalleneinrichtung (20) mit der Pumpeneinrichtung (30) evakuiert wird.

18. Verfahren gemäß einem der Ansprüche 14 bis 17, bei dem
- die erste Kühlfalleneinrichtung (20) mindestens zwei Kühlfallen (21, 22, 23) umfasst, die in getrennten Vakuumverbindungen zwischen der Vakuumkammer (10) und der Pumpeneinrichtung (30) angeordnet sind, wobei
- während der Freigabe des kondensierten Ammoniaks aus einer der Kühlfallen (21, 22, 23) die Kondensation von Ammoniak aus der Vakuumkammer (10) jeweils in einer der anderen Kühlfallen (21, 22) erfolgt.

19. Verfahren gemäß einem der Ansprüche 16 bis 17, mit dem Schritt:
- Kondensation von Restgas an einer zweiten Kühlfalleneinrichtung (50) in der Vakuumkammer (10).

20. Verfahren gemäß Anspruch 19, bei dem
- die zweite Kühlfalleneinrichtung (50) bei einer höheren Betriebstemperatur als die erste Kühlfalleneinrichtung (20) betrieben wird, so dass an der zweiten Kühlfalleneinrichtung (50) kein Ammoniak kondensiert.
